# EUROPÄISCHE PATENTSCHRIFT

(11) **EP 2 483 924 B1**
(45) Veröffentlichungstag und Bekanntmachung des Hinweises auf die Patenterteilung: **17.06.2015**
(21) Anmeldenummer: 10760289.8
(22) Anmeldetag: 20.09.2010
(51) Int. Cl.: G01J 5/12, H01L 27/16, H01L 35/32, H01L 35/34

(54) **THERMO-ELEKTRISCHER ENERGIEWANDLER MIT DREIDIMENSIONALER MIKRO-STRUKTUR, VERFAHREN ZUM HERSTELLEN DES ENERGIEWANDLERS UND VERWENDUNG DES ENERGIEWANDLERS**
THERMO-ELECTRIC ENERGY CONVERTER HAVING A THREE-DIMENSIONAL MICRO-STRUCTURE, METHOD FOR PRODUCING THE ENERGY CONVERTER AND USE OF THE ENERGY CONVERTER
CONVERTISSEUR D'ÉNERGIE THERMO-ÉLECTRIQUE DOTÉ D'UNE MICRO-STRUCTURE TRIDIMENSIONNELLE, PROCÉDÉ DE PRODUCTION DU CONVERTISSEUR D'ÉNERGIE DU CONVERTISSEUR D'ÉNERGIE ET UTILISATION DU CONVERTISSEUR D'ÉNERGIE

(30) Priorität: 29.09.2009 DE 102009043413
(43) Veröffentlichungstag der Anmeldung: 08.08.2012
(73) Patentinhaber: Siemens Aktiengesellschaft, 80333 München (DE)
(72) Erfinder: HEDLER, Harry, 82110 Germering (DE); ZAPF, Jörg, 81927 München (DE)
(86) Internationale Anmeldenummer: PCT/EP2010/063791
(87) Internationale Veröffentlichungsnummer: WO 2011/039068

(56) Entgegenhaltungen:
- EP-A1- 1 612 870
- DE-A1-102006 055 263
- JP-A- 7 283 444
- US-A1- 2002 158 342
- US-A1- 2003 025 174
- US-A1- 2006 266 402
- US-A1- 2008 099 925
- US-A1- 2009 121 136
- US-B1- 6 551 849
- WANG L ET AL: "High aspect ratio through-wafer interconnections for 3D-microsystems", PROCEEDINGS OF THE IEEE 16TH. ANNUAL INTERNATIONAL CONFERENCE ON MICRO ELECTRO MECHANICAL SYSTEMS. MEMS 2003. KYOTO, JAPAN, AN. 19 - 23, 2003; [IEEE INTERNATIONAL MICRO ELECTRO MECHANICAL SYSTEMS CONFERENCE], NEW YORK, NY : IEEE, US, Bd. CONF. 16, 19. Januar 2003 (2003-01-19) , Seiten 634-637, XP010637052, DOI: DOI:10.1109/MEMSYS.2003.1189829 ISBN: 978-0-7803-7744-8

## Beschreibung

Die Erfindung betrifft einen thermo-elektrischen Energiewandler mit dreidimensionaler Mikro-Struktur sowie ein Verfahren zum Herstellen des Energiewandlers und eine Verwendung des Energiewandlers.

Es sind thermo-elektrische Energiewandler bekannt, die auf dem Seebeck-Effekt beruhen. Diese Energiewandler werden als thermo-elektrische Sensoren eingesetzt. Grund-Element eines solchen Energiewandlers ist ein Thermo-Paar mit zwei Thermo-Schenkeln, die aus unterschiedlichen Thermo-Schenkel-Materialien mit unterschiedlicher Thermo-Kraft (Seebeck-Koeffizient) bestehen.

Das Thermo-Paar eines derartigen thermo-elektrischen Energiewandlers ist beispielsweise als zweidimensionale Struktur mit lateralem Aufbau ausgebildet. Die Thermo-Schenkel des Thermo-Paares liegen dabei planar auf einer Membran. Ein warmer Sensor-Kontakt der Thermo-Schenkel ist auf einer Mitte der Membran und ein kalter Sensor-Kontakt der Thermo-Schenkel auf einem die Membran tragenden Silizium-Rahmen angeordnet.

Diese zweidimensionale Struktur hat einen großen Platzbedarf bei einer im Vergleich dazu kleinen thermo-elektrisch aktiven Sensor-Fläche.

Die Druckschrift US 2009/121136 A1 offenbart einen Detektor für elektromagnetische Strahlung mit Thermo-Elementen aus Nanodrähten, welche einen Kern und eine äußere Schicht umfassen, die über eine elektrische Isolationsschicht voneinander isoliert sind.

Das Dokument US 2003/025174 A1 offenbart einen thermo-elektrischen Infrarot-Detektor mit Thermo-Elementen aus zwei Mikro-Säulen.

Die Druckschrift EP 1 612 870 A1 offenbart einen thermo-elektrischen Generator mit Thermö-Paaren aus zwei Schenkeln, wobei die Thermo-Paare zwischen zwei Platten in einem Abstand zu den Platten angeordnet sind.

In der Druckschrift US 2006/266402 A1 werden ein thermo-elektrischer Energiewandler mit Mikro-Säulen aus einer Mehrzahl von Nanodrähten und ein Verfahren zur Herstellung des Energiewandlers beschrieben.

In der Druckschrift L. Wang et al.: "High aspect ratio through-wafer interconnections for 3D-microsystems", Proceedings of the IEEE 16th Annual International Conference on Micro Electro Mechanical Systems, MEMS 2003, Kyoto, Japan, AN. 19-23, 2003; [IEEE International Micro Electro Mechanical Systems Conference], New York, NY: IEEE, US, Bd. CONF. 16, 19. Januar 2003, Seiten 634-637, ist ein Verfahren zur Ausbildung von Durchgangsverbindungen mit einem hohen Aspekt-Verhältnis in einem Wafer offenbart.

Aufgabe der Erfindung ist es, einen thermo-elektrischen Energiewandler mit einem im Vergleich zum Stand der Technik kleineren Platzbedarf bereitzustellen.

Zur Lösung der Aufgabe wird ein thermo-elektrischer Energiewandler zum ineinander Umwandeln von thermischer Energie und elektrischer Energie mit mindestens einem Thermo-Element angegeben. Der Energiewandler weist mindestens eine selbsttragende, dreidimensionale Mikro-Struktur auf mit einer ersten Mikro-Säule, die eine erste Mikro-Säulen-Längsausdehnung, einen ersten Mikro-Säulen Durchmesser und mindestens ein erstes Mikro-Säulen-Material mit einer ersten Thermo-Kraft aufweist, und mindestens einer zweiten Mikro-Säule, die eine zweite Mikro-Säulen-Längsausdehnung, einen zweiten Mikro-Säulen-Durchmesser und mindestens ein zweites Mikro-Säulen-Material mit einer im Vergleich zum Mikro-Säulen-Material unterschiedlichen, zweiten Thermo-Kraft aufweist. Dabei sind die Mikro-Säulen bezüglich der Längsausdehnungen im Wesentlichen parallel zueinander angeordnet. Die Mikro-SäulenDurchmesser sind aus dem Bereich von 0,1 µm bis 200 µm ausgewählt. Die Mikro-Säulen weisen jeweils ein Aspekt-Verhältnis aus dem Bereich von 20 bis 1000 auf. Zudem sind die Mikro-Säulen als Thermo-Paar zum Aufbau einer Thermo-Spannung miteinander gekoppelt. Vorzugsweise sind die Mikro-SäulenDurchmesser aus dem Bereich von 0,3 µm bis 200 µm ausgewählt.

Eine im Wesentlichen parallele Anordnung der Mikro-Säulen bedeutet dabei, dass es hinsichtlich der Ausrichtung der Mikro-Säulen-Längsausdehnungen Abweichungen von bis zu 10° geben kann.

Vorzugsweise weist die Mikro-Struktur eine Vielzahl solcher Thermo-Paare auf. Die Vielzahl der Thermo-Paare ist dabei vorzugsweise seriell miteinander gekoppelt, so dass eine Summe der Thermo-Spannungen der Thermo-Paare im Wesentlichen eine Gesamt-Thermo-Spannung der Vielzahl der Thermo-Paare ergibt. Im Fall thermischer Absorptions-Strahlung ist damit eine extrem hohe Empfindlichkeit von mehr als 1000 V pro Watt eingestrahlter Absorptions-Strahlung möglich.

Erfindungsgemäß sind eine Auslese-Einrichtung (Auslese-Elektronik, Auslese-Schaltkreis) zum Auslesen der Thermo-Spannung des Thermo-Paares und/oder eine Ansteuer-Einrichtung (Ansteuer-Elektronik, Ansteuer-Schaltkreis) zum Ansteuern des Thermo-Paares mit einer elektrischen Ansteuer-Spannung vorhanden. Dabei sind diese Einrichtungen oder Teile davon in einen Mikro-Struktur-Träger integriert. Die Mikro-Struktur ist auf dem Mikro-Struktur-Träger (Mikro-Struktur-Substrat) angeordnet. Ein Substrat-Material kann dabei ein organisches oder anorganisches Material sein. Beispielsweise ist der Mikro-Struktur-Träger ein Silizium-Wafer. Das Substrat-Material ist Silizium. Vorzugsweise wird dazu als Mikro-Struktur-Träger ein Silizium-Wafers verwendet. Die Auslese-Einrichtung und/oder die Ansteuer-Einrichtung sind in den Silizium-Wafer als ASIC(Application Specific Integrated Circuit) eingebracht.

Alternativ sind die Auslese-Einrichtung und/oder die Ansteuer-Einrichtung in einen vom Mikro-Struktur-Träger verschiedenen Schaltungs-Träger (Schaltungs-Substrat) integriert. Die Einrichtungen sind über ein separates Schaltungs-Substrat realisiert. Hier können ebenfalls SMD-Bauteile vorgesehen sein. Der Schaltungs-Träger ist aber vorzugsweise auch ein Silizium-Wafer. Auch hier lassen sich die Einrichtungen als ASICs integrieren. Denkbar ist im Übrigen auch, dass ein Teil der Auslese-Schaltkreises im Mikro-Struktur-Träger und ein weiterer Teil des Auslese-Schaltkreises im Schaltungs-Träger integriert sind.

Bei Integration der Auslese-Einrichtung und/oder der Ansteuer-Einrichtung in einem separaten Schaltungs-Träger ist es besonders vorteilhaft, den Mikro-Struktur-Träger und den Schaltungs-Träger über Flip-Chip-Technologie miteinander verbinden. Mit Hilfe der Flip-Chip-Technologie werden die für das Auslesen bzw. Ansteuern notwendigen elektrischen Kontakte Platz sparend hergestellt. Es resultiert ein kompakter Aufbau des thermo-elektrischen Energiewandlers.

Zur Lösung der Aufgabe wird auch ein Verfahren zum Herstellen eines erfindungsgemäßen thermo-elektrischen Energiewandlers mit folgenden Verfahrensschritten angegeben: a) Bereitstellen einer Schablone mit Schablonen-Material, wobei die Schablone eine im Wesentlichen zur Mikro-Struktur des thermo-elektrischen Energiewandler inverse, drei dimensionale Schablonen-Struktur mit säulenartigen Schablonen-Hohlräumen aufweist, b) Anordnen der Mikro-Säulen-Materialien in den säulenartigen Hohlräumen, so dass die Mikro-Säulen entstehen, und
c) zumindest teilweises Entfernen des Schablonen-Materials. Vorzugsweise werden zum Anordnen des Mikro-Säulen-Materialien folgende weiteren Verfahrensschritte durchgeführt: d) Einbringen von Ausgangs-Material zumindest einer der Mikro-Säulen-Materialien in die Hohlräume und e) Umwandeln des Ausgangs-Materials des Mikro-Säulen-Materials in das Mikro-Säulen-Material.

Mit Hilfe der Mikro-Struktur wird eine dritte Dimension genutzt. Damit gelingt es, den Platzbedarf des Thermo-Paares eines thermo-elektrischen Energiewandlers im Vergleich zum Stand der Technik deutlich zu verringern. Mit der Mikro-Struktur ist es möglich, eine Vielzahl von Thermo-Paaren auf kleinstem Raum anzuordnen. Somit resultiert ein thermo-elektrischer Energiewandler mit einer bürstenartigen, dreidimensional aufgebaute Mikro-Struktur, die aus (systematisch) matrixartig angeordneten, extrem dünnen Mikro-Säulen (Fäden, Nadeln) besteht. Die Mikro-Struktur weist ein Raster mit Raster-Punkten auf. Die Raster-Punkte werden von den Mikro-Säulen gebildet. Bisher gibt es kein Verfahren dafür, eine solche Mikro-Struktur mit einem (Faden)Raster von kleiner 10 µm bei einer Fadenlänge von bis zu 1000 µm und mehr herzustellen.

Der thermo-elektrische Energiewandler beruht auf dem Seebeck-Effekt. Dabei wird thermische Energie in elektrische Energie umgewandelt. Die Mikro-Säulen sind die Thermo-Schenkel des Thermo-Paares. Der thermo-elektrische Energiewandler kann aber auch umgekehrt unter Ausnutzung des Peltier-Effekts betrieben werden. Dabei wird das Thermo-Paar von elektrischem Strom durchflossen. Die dabei frei werdende thermische Energie kann an die Umgebung abgegeben werden. Dies führt je nach Situation zur Erwärmung oder zur Kühlung der Umgebung.

Als Mikro-Säulen-Materialien kommt eine Vielzahl von Materialien in Frage, so zum Beispiel Metalle, Legierungen der Metalle, Halbmetalle und halbleitende Verbindungen. Insbesondere weisen das erste Mikro-Säulen-Material und/oder das zweite Mikro-Säulen-Material ein aus der Gruppe Wismut, Antimon, Tellur und Blei ausgewähltes Element auf. Die Mikro-Säulen-Materialien können nur aus jeweils einem der Elemente bestehen. Denkbar sind auch Legierungen dieser Elemente sowie Verbindungen davon. Dabei ist vor allen Dingen Wismut-Tellurid (Bi₂Te₃) hervorzuheben, das bei Raumtemperatur ein sehr effizientes Thermo-Schenkel-Material ist. Weitere geeignete Materialien sind folgende Zusammensetzungen: Wismut-Antimon (BiSb), Blei-Tellur (PbTe) oder Silicium-Germanium (SiGe).

Die grundlegende Idee zur Herstellung der Mikro-Struktur besteht darin, basierend auf einer Schablone (Matrix, Template) eine zur Mikro-Struktur inverse Schablonen-Struktur (Matrix-Struktur) mit Schablonen-Hohlräumen bereitzustellen. Die Schablo-nen-Hohlräume sind bezüglich ihrer Schablonen-Hohlraum-Längsdehnungen im Wesentlichen parallel zueinander ausgerichtet und weisen jeweils ein Aspekt-Verhältnis aus dem Bereich von 20 bis 1000 und jeweils einen Schablonen-Hohlraum-Durchmesser aus dem Bereich von 0,1 µm bis 200 µm auf. Auch ein Abstand zwischen den benachbarten Schablonen-Hohlräumen entspricht einem Mikro-Säulen-Abstand der Mikro-Struktur. Über dieses Herstellverfahren wird die dritte Dimension zur Realisierung des thermo-elektrischen Energiewandlers genutzt.

Die Mikro-Säulen sind vorzugsweise nebeneinander angeordnet. Denkbar ist aber auch, dass die Mikro-Säulen übereinander angeordnet sind. Dabei stehen die Mikro-Säulen bevorzugt in direktem Kontakt miteinander. Gemäß einer besonderen Ausgestaltung sind daher die Mikro-Säulen übereinander zu einer Gesamt-Mikro-Säule mit einer Gesamt-Längsausdehnung aneinander angeordnet. Die erste Mikro-Säule und die zweite Mikro-Säule bilden Abschnitte der Gesamt-Mikro-Säule.

Vorzugsweise ist die Mikro-Säulen-Längsausdehnung zumindest einer der Mikro-Säulen oder die Gesamt-Mikro-Säulen-Längsausdehnung der Gesamt-Mikro-Säule aus dem Bereich von 50 µm bis 10 mm und insbesondere aus dem Bereich von 100 µm bis 1 mm ausgewählt. Insbesondere sind die Mikro-Säulen-Längsausdehnungen (Fadenlängen) einer Vielzahl der Mikro-Säulen bzw. aller Mikro-Säulen aus den genannten Bereichen ausgewählt. Dabei können die Mikro-Säulen gleich lang sein. Denkbar ist auch, dass die Mikro-Säulen der Mikro-Struktur unterschiedlich lang sind, also unterschiedliche Mikro-Säulen-Längsausdehnungen aufweisen.

Wie bereits erwähnt, können die Mikro-Säulen übereinander angeordnet sein. Vorzugsweise sind die Mikro-Säulen aber nebeneinander angeordnet. Gemäß einer besonderen Ausgestaltung sind die Mikro-Säulen derart nebeneinander angeordnet, das zwischen den Mikro-Säulen ein Mikro-Säulen-Zwischenraum mit einem zwischen den Mikro-Säulen aus dem Bereich von 0,3 µm bis 100 µm ausgewählten Mikro-Säulen-Abstand resultiert. Aufgrund der geringen Mikro-Säulen-Durchmesser (lateralen Ausdehnungen) der Mikro-Säulen und des geringen Mikro-Säulen-Abstandes zwischen den Mikro-Säulen ergibt sich ein extrem geringer Platzbedarf für das Thermo-Paar des thermoelektrischen Energiewandlers.

Bei diesen geringen Mikro-Säulen-Abständen ist vorzugsweise im Mikro-Säulen-Zwischenraum zwischen den benachbarten Mikro-Säulen mindestens ein Mittel zur thermischen Entkopplung der Mikro-Säulen voneinander angeordnet. Ein lateraler WärmeAustausch bzw. ein lateraler Wärme-Tränsport über den Mikro-Säulen-Zwischenraum hinweg wird unterbunden. Das Mittel kann ein Material mit einer geringen thermischen Leitfähigkeit sein. Insbesondere ist das Mittel zum thermischen Entkoppeln Vakuum mit einem Gasdruck von weniger als 10⁻² mbar. Insbesondere beträgt der Gasdruck weniger als 10⁻³ mbar. Die Mikro-Struktur mit den Mikro-Säulen ist evakuiert.

In einer besonderen Ausgestaltung weist die Mikro-Struktur des thermo-elektrischen Energiewandlers mindestens eine Wärme-Kopplungs-Einrichtung zum Einkoppeln von thermischer Energie in das Thermo-Paar und/oder zum Auskoppeln von thermischer Energie aus dem Thermo-Paar auf. Insbesondere weist die Wärme-Kopplungs-Einrichtung eine thermische Funktions-Schicht zum Absorbieren von thermischer Energie in Form von thermischer Absorptions-Strahlung und/oder zum Emittieren von thermischer Energie in Form von thermischer Emissions-Strahlung auf. Die thermische Funktions-Schicht absorbiert elektromagnetische Strahlung, beispielsweise sichtbares Licht oder Infrarot-Licht. Die dabei aufgenommene thermische Energie wird an das Thermo-Paar weitergeleitet. Umgekehrt kann die beim Stromfluss durch das Thermo-Paar frei werdende Energie über die Funktions-Schicht als elektromagnetische Strahlung (Emissions-Strahlung) an die Umgebung abgegeben werden.

Denkbar ist auch, dass die Wärme-Kopplungs-Einrichtung eine chemisch sensitive Beschichtung aufweist. An diese chemisch sensitive Beschichtung adsorbieren bestimmte chemische Substanzen, beispielsweise bestimmte Gase. Bei der Absorption von solchen Gasmolekülen an die chemisch sensitive Beschichtung wird thermische Energie frei, die dann durch den thermo-elektrischen Energiewandler detektierbar ist.

Im Hinblick auf das Verfahren wird insbesondere eine Schablone mit Silizium als Schablonen-Material verwendet. Beispielsweise wird das Verfahren mit Hilfe eines Silizium-Wafers durchgeführt. Der Silizium-Wafer fungiert als Schablone. Silizium eignet sich besonders gut für die Erzeugung der oben beschriebenen säulenartigen Schablonen-Hohlräume mit den notwendigen Aspekt-Verhältnissen. Dazu wird der PAECE (Photo Assisted Electro-Chemical Etching)-Prozess durchgeführt. Ausgangspunkt dieses Verfahrens ist ein Einbringen von "Ätz-Grübchen" (etch pits) in eine Oberfläche des Silizium-Wafers, beispielsweise durch Photolithographie. Dieser oberflächenstrukturierte Silizium-Wafer wird einer Ätz-Lösung mit Fluss-Säure ausgesetzt. Durch Einwirken eines elektrischen Feldes und durch Bestrahlen mit Licht entstehen ausgehend von den "Ätz-Grübchen" mit einer extremen Struktur-Treue die säulenartigen Schablonen-Höhlräume.

Neben der Erzeugung der säulenartigen Schablonen-Hohlräume ist das Befüllen der Schablonen-Hohlräume ein weiterer wesentlicher Schritt. Die Schablonen-Hohlräume werden dazu beispielsweise mit flüssigem Mikro-Säulen-Material als Ausgangs-Material oder einem anderen flüssigen Ausgangs-Material des Mikro-Säulen-Materials befüllt. Nachfolgend kommt es in den Schablonen-Hohlräumen zur Umsetzung des flüssigen Materials in das feste Mikro-Säulen-Material. Es bilden sich die Mikro-Säulen.

Beispielsweise wird bei erhöhter Temperatur flüssiges Metall als Ausgangs-Material in die Schablonen-Hohlräume eingebracht. Anschließend wird die Temperatur erniedrigt. Das flüssige Metall erstarrt und es entstehen die entsprechenden Mikro-Säulen aus dem Metall.

Denkbar ist auch, dass die Schablonen-Hohlräume als Mikro-Reaktoren fungieren. Dabei wird flüssiges Ausgangs-Material in die Schablonen-Hohlräume eingebracht. Eine anschließende chemische Reaktion führt zur Bildung des Mikro-Säulen-Materials. Es entstehen die Mikro-Säulen.

Nach der Bildung der Mikro-Säulen wird das Schablonen-Material zumindest zum Teil entfernt. Dies bedeutet, dass die Mikro-Säulen teilweise oder vollständig freigelegt werden. Wenn die Mikro-Säulen nur teilweise freigelegt werden, kann der verbleibende Rest der Schablone als Mikro-Struktur-Träger fungieren. Denkbar ist aber auch, dass eine Schablone mit einem Mikro-Struktur-Träger für die Mikro-Struktur verwendet wird. So verbleibt nach vollständiger Entfernung des Schablonen-Materials die Mikro-Struktur auf dem Mikro-Struktur-Träger.

Nach dem Entfernen des Schablonen-Materials kann eine oben beschriebene thermische Funktions-Schicht mit entsprechendem Funktions-Material an den Enden der Mikro-Säulen angeordnet werden. Es wird dafür gesorgt, dass an den Enden zumindest eines Teils der Mikro-Säulen die Funktions-Schicht mit dem Funktions-Material angeordnet ist.

Eine erste Mikro-Säule und eine zweite Mikro-Säule können zu einer Gesamt-Mikro-Säule übereinander angeordnet werden. Die Gesamt-Mikro-Säule weist zwei entlang der Gesamt-Mikro-Säulen-Längsausdehnung angeordnete Abschnitte mit voneinander unterschiedlichen Mikro-Säulen-Materialien auf. Die Gesamt-Mikro-Säule besteht aus zwei Abschnitten (Teil-Abschnitten) mit unterschiedlichen Mikro-Säulen-Materialien. Dies wird beispielsweise dadurch erreicht, dass die Schablonen-Hohlräume zunächst mit erstem Mikro-Säulen-Materiäl teilweise befüllt werden. Nach dem Ausbilden der ersten Mikro-Säulen werden die frei gebliebenen Bereiche der Schablonen-Hohlräume mit zweitem Mikro-Säulen-Material befüllt. Nachfolgendes Umsetzen in das zweite Mikro-Säulen-Material führt dazu, dass eine Gesamt-Mikro-Säule mit einem ersten Abschnitt mit der ersten Mikro-Säule und mit einem zweiten Abschnitt mit der zweiten Mikro-Säule entsteht. Denkbar ist auch, dass die Schablonen-Hohlräume mit den beiden Mikro-Säulen-Materialien von unterschiedlichen Seiten her befüllt werden und in einem einzigen gemeinsamen Prozess in die jeweiligen Mikro-Säulen-Materialien überführt werden.

Vorzugsweise sind erste und zweite Mikro-Säulen nicht übereinander, sondern nebeneinander angeordnet. Es resultiert eine heterogene, aus den unterschiedlichen Mikro-Säulen-Materialien aufgebaute Mikro-Struktur. Diese Mikro-Struktur lässt sich beispielsweise dadurch herstellen, dass während des Anordnens eines der Mikro-Säulen-Materialien ein Teil der Schablonen-Hohlräume abgedeckt wird. Anschließend werden die abgedeckten Schablonen-Hohlräume mit ein em anderen Mikro-Säulen-Material befüllt. Die Mikro-Säulen-Materialien können wieder gleichzeitig in einem gemeinsamen Prozess zu den entsprechenden Mikro-Säulen umgesetzt werden. Es resultiert die Mikro-Struktur mit Mikro-Säulen aus den unterschiedlichen Mikro-Säulen-Materialien. Denkbar ist aber auch eine serielle Herstellung dieser Mikro-Säulen. Dies bedeutet, dass zunächst das erste Mikro-Säulen-Material umgesetzt wird, bevor das zweite Mikro-Säulen-Material in die zuvor abgedeckten Schablonen-Hohlräume eingefüllt und anschließend umgesetzt wird. Auch ist es möglich, zuerst die ersten Mikro-Säulen-Hohlräume herzustellen und mit dem ersten Mikro-Säulen-Material zu befüllen, bevor die zweiten Mikro-Säulen-Hohlräume hergestellt und mit dem zweiten Mikro-Säulen-Material befüllt werden.

Gemäß einem weiteren Aspekt der Erfindung wird eine Verwendung des thermo-elektrischen Energiewandlers zum ineinander Umwandeln von thermischer Energie und elektrischer Energie angegeben, wobei durch die thermische Energie im Thermo-Paar die Thermo-Spannung erzeugt und so in elektrische Energie umgewandelt wird oder durch elektrische Ansteuerung des Thermo-Paares elektrische Energie in thermische Energie umgewandelt wird.

Vorzugsweise wird der thermo-elektrischen Energiewandler dazu verwendet, um aus der elektrischen Energie, die aus der thermischen Energie gewonnen wird, die thermische Energie nachzuweisen. Frei werdende Absorptions-Wärme bei der Absorption von Gas-Molekülen (siehe oben) kann auf diese Weise zum Nachweis der Gas-Moleküle verwendet werden. Somit eignet sich der thermo-elektrische Energiewandler zur Anwendung in der Gas-Analytik.

Vorzugsweise wird thermische Energie in Form thermischer Absorptions-Strahlung (Wärme-Strahlung, Infrarot-Strahlung verwendet. Dies bedeutet, dass der thermo-elektrische Energiewandler zum Nachweis von Wärme-Strahlung verwendet wird. Der thermo-elektrische Energiewandler fungiert als InfrarotSensor. Bei einer Vielzahl von seriell miteinander gekoppelten Thermo-Paaren kann hier eine extrem hohe Empfindlichkeit von mehr als 1000 V pro Watt eingestrahlter Absorptions-Strahlung erreicht werden.

Zudem ist aufgrund des geringen Platzbedarfs eine hohe Pixel-Zahl (Anzahl von Bildpunkten pro Flächen-Einheit) und somit eine hohe Orts-Auflösung der Wärme-Strahlung möglich. Ein Pixel ist dabei von einem oder von mehreren Thermo-Paaren gebildet. Aus der hohen Orts-Auflösung resultieren verschiedenste Anwendungsmöglichkeiten des thermo-elektrischen Energiewandlers, beispielsweise in hochauflösenden Infrarot-Kameras oder Infrarot-Sichtgeräten, in Infrarot-Scannern für die Thermographie in Medizintechnlk und Industrie oder für die Analytik.

Zusammenfassend ergeben sich mit der Erfindung folgende Vorteile:
- Mit der dreidimensionalen Mikro-Struktur ist eine große Anzahl an Thermo-Paaren pro Flächen-Einheit möglich.
- Mit der großen Anzahl an Thermo-Paaren pro Fläche-Einheit ist ein Sensor für thermische Energie mit einer hohen Ortsauflösung zugänglich.
- Mit Hilfe der Erfindung können thermo-elektrische Energiewandler mit lateral ausgedehnten Sensorflächen hergestellt werden. Es sind also großflächige Thermo-Detektoren mit hoher Auflösung möglich.
- Die extrem dünnen (bis in den Bereich von Bruchteilen von Mikrometern) und extrem langen (bis in den Bereich von mehreren Millimetern) Mikro-Säulen führen zu einer hohen Empfindlichkeit.
- Die Mikro-Struktur weist Selbst-tragende Mikro-Säulen auf. Sie bedarf daher keiner Auflagefläche zum Stützen Mikro-Struktur.
- Zwischen benachbarten Pixeln kommt es zu einer geringen Wärme-Übertragung, insbesondere bei Verwendung eines Schutzgases oder von Vakuum. Dies führt zusätzlich zu einer erhöhten Empfindlichkeit und einer erhöhten Ortsauflösung.
- Die Mikro-Säulen können definiert und reproduzierbar erzeugt werden.
- Für die Mikro-Säulen-Materialien gibt es aufgrund der einfachen Prozess-Technik zum Befüllen der Schablonen-Hohlräume eine große Material-Auswahl.
- Bei Verwendung eines Schaltungs-Trägers mit integrierter Auslese- bzw. Ansteuer-Elektronik, der über die Flip-Chip-Technologie mit dem Mikro-Struktur-Träger verbunden ist, ergibt sich eine laterale Ausdehnung des gesamten thermo-elektrischen Energiewandlers, die nicht wesentlich größer ist als eine durch die Mikro-Struktur bestimmte Fläche. Eine Dicke des thermo-elektrischen Energiewandlers bestimmt sich durch die auf dem Mikro-Struktur-Träger angeordnete Mikro-Struktur und dem Schaltungs-Träger. Die Dicke des Energiewandlers entspricht also der Dicke zweier gestapelter Chips.

Anhand mehrerer Ausführungsbeispiele und der dazugehörigen Figuren wird die Erfindung im Folgenden näher beschrieben. Die Figuren sind schematisch und stellen keine maßstabsgetreuen Abbildungen dar.

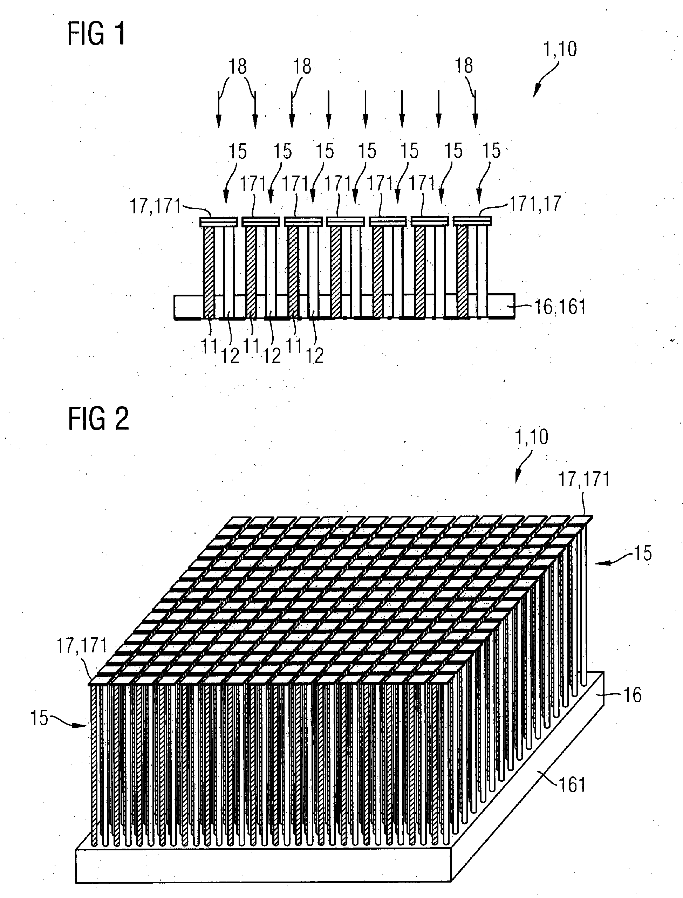

- Figur 1: zeigt eine dreidimensionale Mikrostruktur eines thermo-elektrischen Energiewandler in einen seitlichen Querschnitt.
- Figur 2: zeigt die Mikro-Struktur in perspektivischer Darstellung.
- Figur 3: zeigt das grundlegende Verfahren zum Herstellen der Mikro-Struktur.
- Figur 4: zeigt ein Verfahren zum Befüllen von Schablonen-Hohlräumen einer Schablone.
- Figuren 5A und 5B: zeigen ein Verfahren zum Herstellen eines thermo-elektrischen Energiewandlers.
- Figuren 6A und 6B: zeigen ein Verfahren zum Herstellen eines weiteren thermo-elektrischen Energiewandlers.
- Figuren 7A und 7B: zeigen ein Verfahren zum Kontaktieren des Mikro-Struktur-Trägers und eines Schaltungs-Trägers mit Auslese-Elektronik.
- Figur 8: zeigt einen Ausschnitt eines Thermo-Paares nebeneinander angeordneten Mikro-Säulen.
- Figur 9: zeigt einen Ausschnitt eines Thermo-Paares mit übereinander angeordneten Mikro-Säulen.

Gegenstand der nachfolgenden Beispiele ist jeweils ein thermo-elektrischer Energiewandler 1 zum Umwandeln von thermischer Energie und elektrischer Energie. Die Funktionsweise des Energie-Wandlers basiert auf dem Seebeck-Effekt. Ausgestaltet ist der thermo-elektrische Energiewandler als Infrarot-Sensor zur Detektion von Wärme-Strahlung 18.

Der Energiewandler verfügt über mindestens eine selbsttragende, dreidimensionale Mikro-Struktur 10. Die Mikro-Struktur 10 weist eine Vielzahl von Thermo-Paaren 15 zum Aufbau einer Thermo-Spannung auf. Die Thermo-Paare sind seriell verschaltet, so dass sich die Thermo-Spannungen der einzelnen Thermo-Paare aufaddieren.

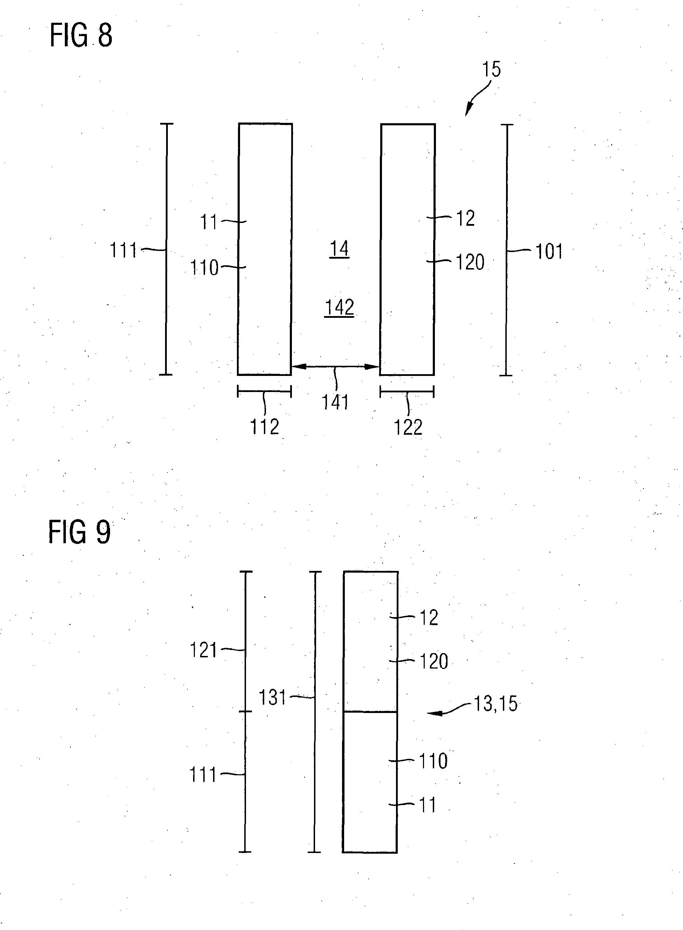

Jedes der Thermo-Paare weist mindestens eine erste, selbsttragende Mikro-Säule 11 auf, die eine ersten Mikro-Säulen-Längsausdehnung 111, einen ersten Mikro-Säulen-Durchmesser 112 und mindestens ein erstes Mikro-Säulen-Material 110 mit einer ersten Thermo-Kraft aufweist (Figur 8). Das erste Mikro-Säulen-Material ist Wismut-Tellurid (Bi₂Te₃).

Jedes der Thermo-Paare weist auch mindestens eine zweite, selbst-tragende Mikro-Säule 12 auf, die eine zweite Mikro-Säulen-Längsausdehnung 121, einen zweiten Mikro-Säulen-Durchmesser 122 und mindestens ein zweites Mikro-Säulen-Material 120 mit einer im Vergleich zum ersten Mikro-Säulen-Material unterschiedlichen, zweiten Thermo-Kraft aufweist. Das zweite Mikro-Säulen-Material ist elementares Molybdän.

Die Mikro-Säulen sind bezüglich der Mikro-Säulen-Längsausdehnungen im Wesentlichen parallel zueinander angeordnet. Die Mikro-Säulen-Durchmesser betragen etwa 0,3 µm und die Mikro-Säulen-Längsausdehnungen 120 µm. Das Aspekt-Verhältnis jeder der Mikro-Säulen beträgt somit etwa 400.

Zwischen benachbarten Mikro-Säulen ist ein Mikro-Säulen-Zwischenraum 14 vorhanden. Der Mikro-Säulen-Zwischenraum weist einen Mikro-Säulen-Abstand 141 zwischen benachbarten Mikro-Säulen aus dem Bereich von etwa 0,3 µm auf.

Im Mikro-Säulen-Zwischenraum ist in einer Ausführungsform ein Schutzgas angeordnet. In einer dazu alternativen Ausführungsform ist der Mikro-Säulen-Zwischenraum evakuiert. Das Schutzgas oder das Vakuum im Zwischenraum fungieren als Mittel 142 zum voneinander thermischen Entkoppeln der Mikro-Säulen.

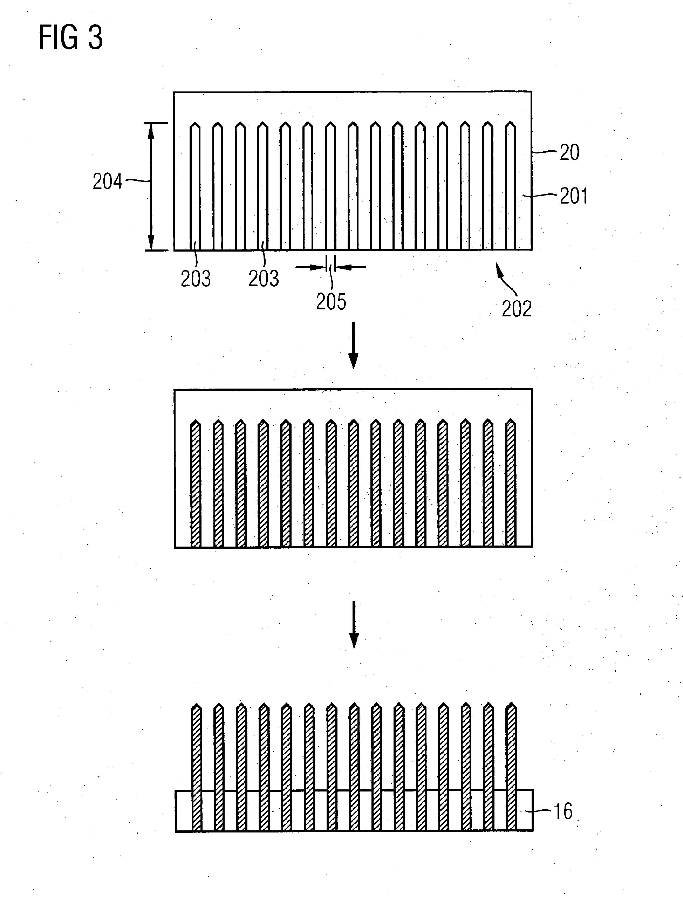

Die Mikro-Struktur ist mit einem Mikro-Säulen-Träger 16 verbunden, der aus der verwendeten Schablone 20 durch teilweises Entfernen des Schablonen-Materials 201 hervorgeht (Figur 3). Das Träger-Material 161 des Mikro-Säulen-Trägers ist das Schablonen-Material der Schablone. In einer alternativen Ausführungsform verbleibt die Mikro-Struktur auf einem Mikro-Säulen-Träger, der im Verlauf des Herstellungsverfahrens mit der Schablone verbunden wurde. Das Schablonen-Material wird vollständig entfernt. Übrig bleibt die Mikro-Struktur auf dem Träger.

Zum Herstellen der dreidimensionalen Mikro-Struktur werden folgende Verfahrensschritte durchgeführt: a) Bereitstellen einer Schablone mit Schablonen-Material, wobei die Schablone eine im Wesentlichen zur Mikro-Struktur des thermo-elektrischen Energiewandlers inverse, dreidimensionale Schablonen-Struktur mit säulenartigen Schablonen-Hohlräumen aufweist, b) Anordnen der Mikro-Säulen-Materialien in den säulenartigen Hohlräumen, so dass die Mikro-Säulen entstehen, und c) zumindest teilweises Entfernen des Schablonen-Materials (Figur 3). Zum Anordnen der Mikro-Säulen-Materialien werden folgende weiteren Verfahrensschritte durchgeführt: d) Einbringen von Ausgangs-Material zumindest einer der Mikro-Säulen-Materialien in die Hohlräume und e) Umwandeln des Ausgangs-Materials des Mikro-Säulen-Materials in das Mikro-Säulen-Material.

Ausgangspunkt ist ein Silizium-Wafer. Dieser Silizium-Wafer dient als Schablone. Das Schablonen-Material 201 ist Silizium. Mit Hilfe des PAECE-Prozesses werden die Schablonen-Hohlräume 203 in den Silizium-Wafer eingebracht. Die Schablonen-Hohlräume werden mit Hohlraum-Längsausdehnung 204 und Hohlraum-Durchmesser 205 eingebracht, die den herzustellenden Mikro-Säulen entsprechen. Auch die Abstände zwischen den Schablonen-Hohlräumen werden entsprechend den Abständen der Mikro-Säulen gewählt. Es entsteht die Schablonen-Struktur 202.

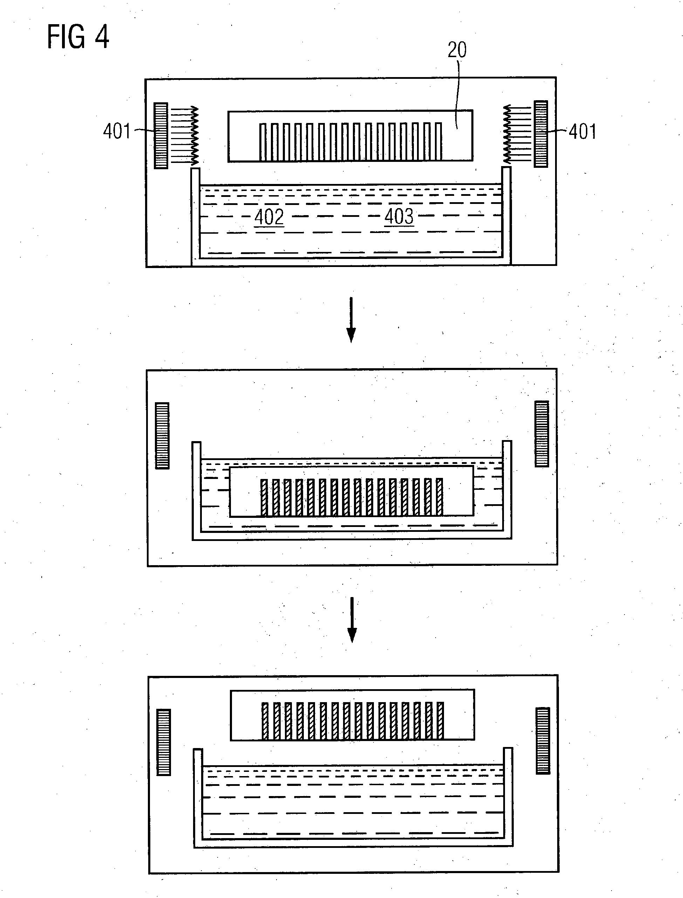

Nachfolgend werden die säulenartigen Schablonen-Hohlräume mit flüssigem Mikro-Struktur-Material befüllt. Dieses Vorgehen ist beispielhaft in Figur 4 dargestellt: Die Schablone mit den Schablonen-Hohlräumen wird mit Hilfe der Heiz-Elemente 401 erwärmt und in ein Reservoir 402 mit flüssigem Metall 403 getaucht. Durch Variation eines äußeren Drucks wird dafür gesorgt, dass das flüssige Metall in die Schablonen-Hohlräume eindringt. Anschließend wird die Schablone mit den gefüllten Schablonen-Hohlräumen aus dem Reservoir entfernt. Die Schablone kühlt ab. Also Folge davon erstarrt das Metall in den Schablonen-Hohlräumen. Es entstehen die Mikro-Säulen aus dem Metall. Das flüssige Metall dient als Ausgangs-Material des Mikro-Struktur-Materials. Es wird durch Abkühlung in das Mikro-Struktur-Material (festes Metall) überführt.

### Beispiel 1:

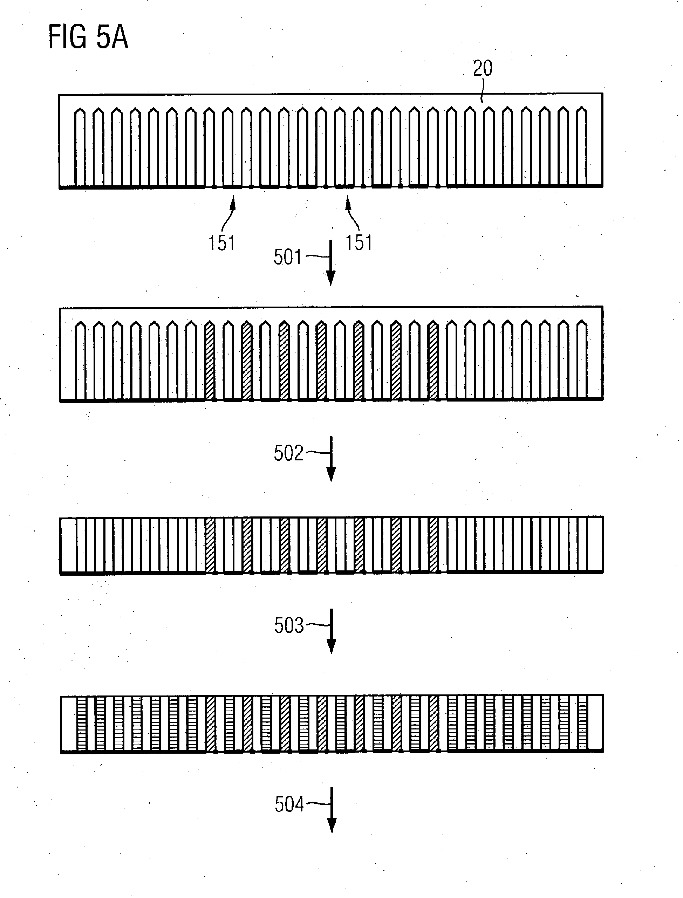

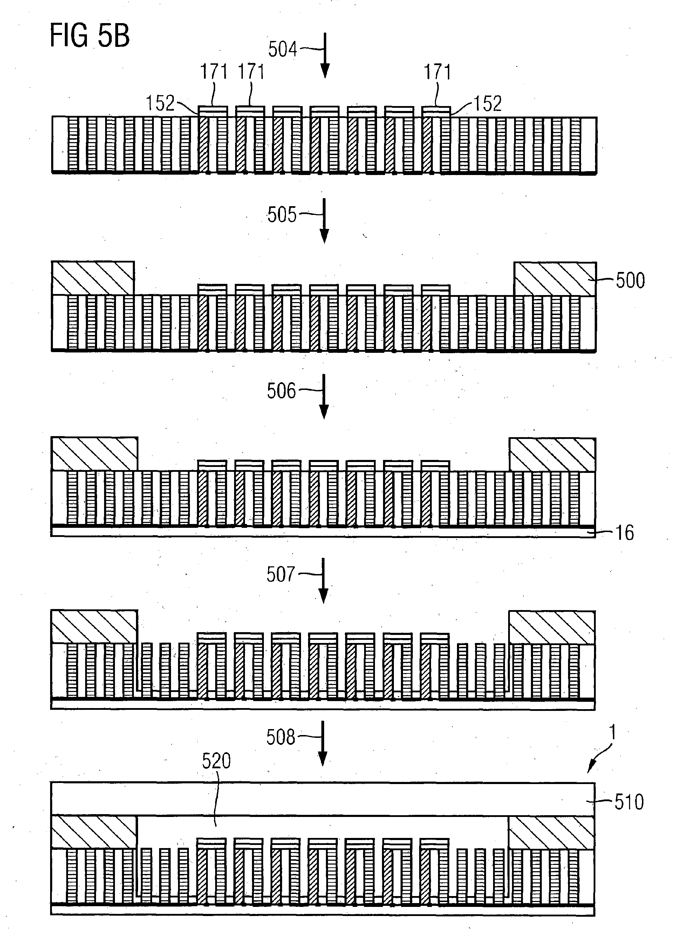

Nach Passivierung und PAECE-Prozess werden die "kalten Kontakte" 151 der Thermo-Paare erzeugt (Figuren 5A und 5B).

Im Folgenden wird flüssiges Ausgangs-Material des ersten Mikro-Säulen-Materials in einen Teil der Schablonen-Hohlräume eingebracht (Schritt 501). Das erste Mikro-Säulen-Material weist eine höhere Schmelztemperatur auf, als das zweite Mikro-Säulen-Material. Es entstehen die ersten Mikro-Säulen.

Nach Entfernen von Schablonen-Material auf der anderen Seite der Schablone und Planarisierung (Schritt 502) werden die zweiten Mikro-Säulen in den verbleibenden Schablonen-Hohlräumen angeordnet (Schritt 503).

Im Weiteren werden die heißen Kontakte 152 der Thermo-Paare erzeugt. Zudem wird auch jeweils eine Absorptions-Schicht 171 für die zu detektierende Wärme-Strahlung aufgebracht (Schritt 504).

Im darauf folgenden Schritt 505 wird ein Distanz-Element 500 auf der Mikro-Struktur angeordnet. Optional wird noch ein Mikro-Struktur-Träger 16 oder eine abschließende Schicht angeordnet (Schritt 506).

Danach wird in einem Ätz-Schritt Schablonen-Material der Schablone entfernt (Schritt 507). Silizium des als Schablone eingesetzten Silizium-Wafers wird entfernt.

Zuletzt wird noch ein Infrarot-Fenster 510 aufgebracht, das für die zu detektierende Wärme-Strahlung durchlässig ist. Darüber hinaus wird der sich daraus ergebende Innenraum 520 evakuiert. Der Innenraum ist von der Mikro-Struktur, dem Distanz-Element und dem Infrarot-Fenster begrenzt. In Folge des Evakuierens sind die Mikro-Säulen-Zwischenräume der Mikro-Struktur evakuiert.

### Beispiel 2:

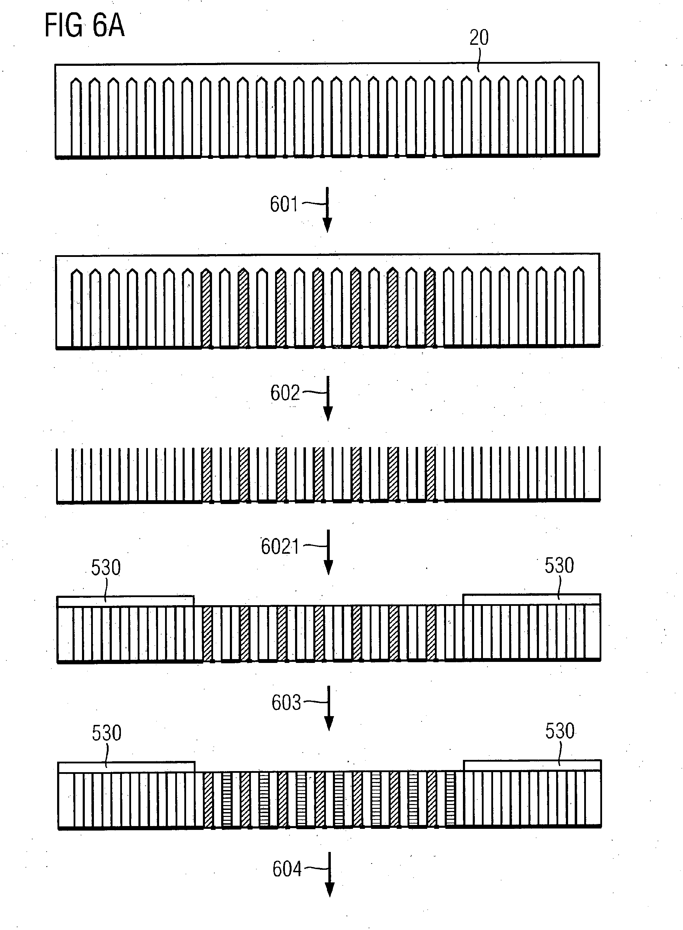

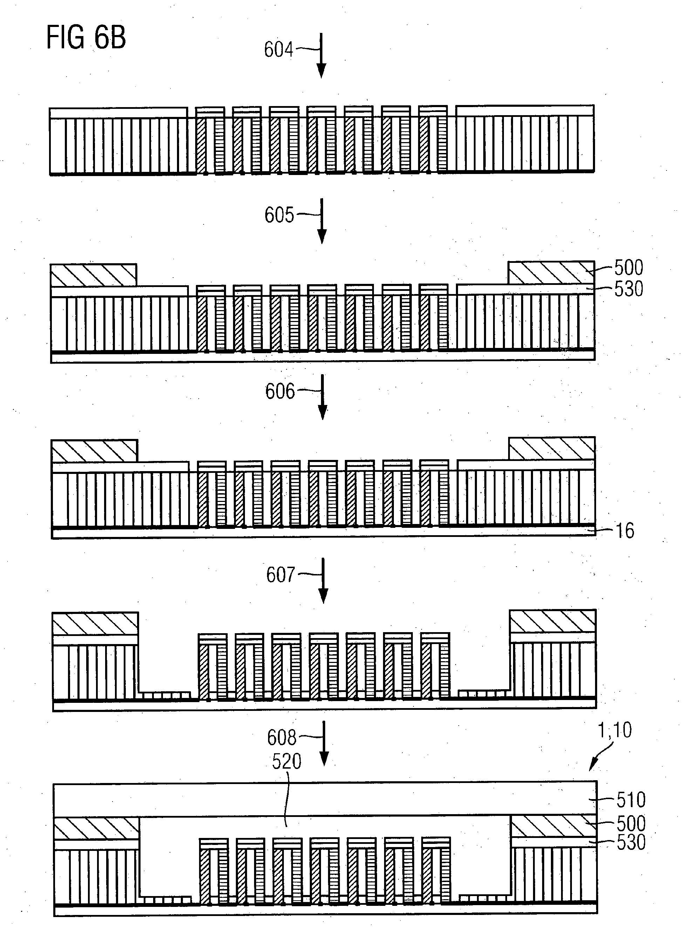

Identisch sind die Schritte 601 - 606 und 608 des Beispiels 2 (Figuren 6A und 6B) und die entsprechenden Schritte 501 - 506 und 508 des Beispiels 1. Im Unterschied zu Beispiel 1 wird nach dem Anordnen der ersten Mikro-Säulen im Schritt 6021.ein Rahmen 503 aufgebracht. Über den Rahmen wird ein Teil der noch nicht befüllten Schablonen-Hohlräume abgedeckt. Diese Schablonen-Hohlräume bleiben im weiteren Verlauf des Verfahrens frei, werden also nicht befüllt.

Ein weiterer Unterschied ist im Schritt 607 gegeben: Der nicht durch das Distanz-Element abgedeckte Teil des Rahmes 503 wird im Silizium-Ätz-Prozess mit entfernt. Es resultiert ein größerer, im weiteren Verlauf noch zu evakuierender Innenraum.

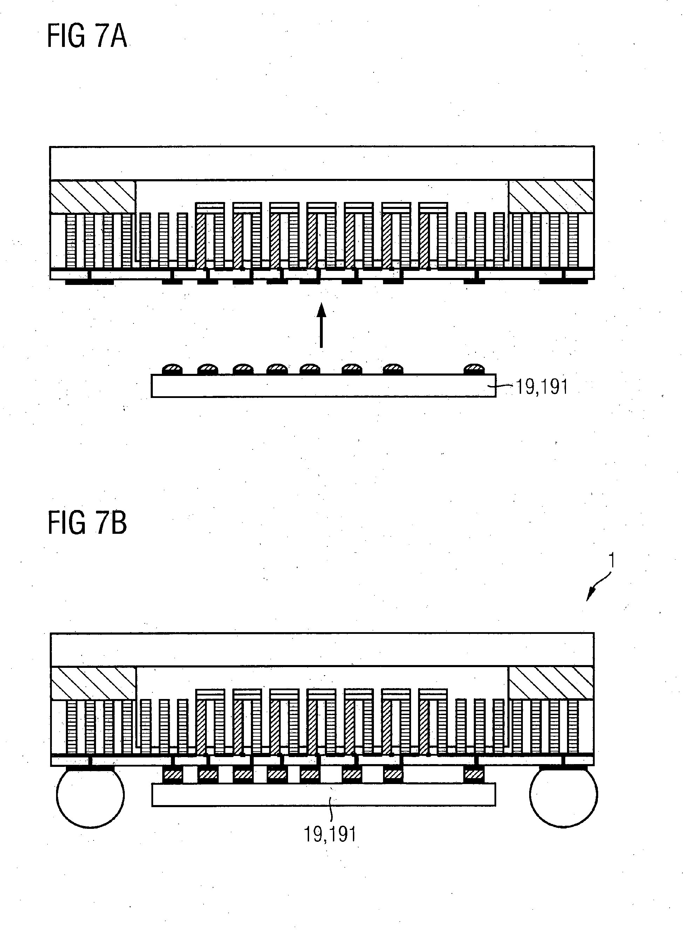

Den Abschluss bildet die Verbindung des Mikro-Struktur-Trägers mit einem Schaltungs-Träger 19 bzw. die elektrische Kontaktierung der Thermo-Paare der Mikro-Struktur mit einer im Schaltungs-Träger als ASIC integrierten Auslese-Einrichtung 191. Dies ist in den Figuren 7A und 7B dargestellt. Der Mirko-Struktur-Träger und der Schaltungs-Träger werden mit Hilfe der Flip-Chip-Technologie miteinander verbunden. Die Kontaktierung erfolgt dabei von der Rückseite des thermo-elektrischen Energiewandlers her. Es kommt zu keiner Abschattung der thermisch sensitiven Elemente des Energiewandlers.

### Beispiel 3:

Entgegen der vorangegangenen Beispiele sind die erste und die zweite Mikro-Säule eines Thermo-Paares nicht nebeneinander, sondern übereinander zu einer Gesamt-Mikro-Säule 13 mit einer Gesamt-Mikro-Säulen-Längsausdehnung 131 angeordnet (Figur 9). Ein Gesamt-Mikro-Säulen-Durchmesser entspricht den Mikro-Säulen-Durchmessern der ersten und zweiten Mikro-Säule. Der thermo-elektrische Energiewandler weist, eine Vielzahl derartiger Gesamt-Mikro-Säulen auf.

## Patentansprüche

1. Thermo-elektrischer Energiewandler (1) zum ineinander Umwandeln von thermischer Energie und elektrischer Energie mit mindestens einem Thermo-Element, aufweisend mindestens eine selbst-tragende, dreidimensionale Mikro-Struktur (10) mit
- mindestens einer ersten Mikro-Säule (11), die eine ersten Mikro-Säulen-Längsausdehnung (111), einen ersten Mikro-Säulen-Durchmesser (112) und mindestens ein erstes Mikro-Säulen-Material (110) mit einer ersten Thermo-Kraft aufweist, und
- mindestens einer zweiten Mikro-Säule (12), die eine zweite Mikro-Säulen-Längsausdehnung (121), einen zweiten Mikro-Säulen-Durchmesser (122) und mindestens ein zweites Mikro-Säulen-Material (120) mit einer im Vergleich zum ersten Mikro-Säulen-Material unterschiedlichen, zweiten Thermo-Kraft aufweist,
wobei
- die Mikro-Säulen bezüglich der Längsausdehnungen (111, 121) im Wesentlichen parallel zueinander angeordnet sind,
- die Mikro-Säulen-Durchmesser (112, 122) aus dem Bereich von 0,1 µm bis 200 µm ausgewählt sind,
- die Mikro-Säulen (11, 12) jeweils ein Aspekt-Verhältnis aus dem Bereich von 20 bis 1000 aufweisen und
- die Mikro-Säulen als Thermo-Paar (15) zum Aufbau einer Thermo-Spannung miteinander gekoppelt sind,
- wobei eine Auslese-Einrichtung (191) zum Auslesen der Thermo-Spannung des Thermo-Paares und/oder eine Ansteuer-Einrichtung zum Ansteuern des Thermo-Paares mit einer elektrischen Ansteuer-Spannung vorhanden sind,
**dadurch gekennzeichnet, dass**
die Auslese-Einrichtung und/oder die Ansteuer-Einrichtung oder Teile davon in einen Mikro-Struktur-Träger, auf dem die Mikro-Struktur angeordnet ist, integriert sind und/oder dass die Auslese-Einrichtung und/oder die Ansteuer-Einrichtung oder Teile davon in einen vom Mikro-Struktur-Träger verschiedenen Schaltungs-Träger (19) integriert sind.

2. Thermo-elektrischer Energiewandler nach Anspruch 1, wobei das erste Mikro-Säulen-Material und/oder das zweite Mikro-Säulen-Material aus der Gruppe Wismut, Antimon, Tellur und Blei sowie Verbindungen davon ausgewählt sind.

3. Thermo-elektrischer Energiewandler nach Anspruch 1 oder 2, wobei die Mikro-Säulen-Durchmesser aus dem Bereich von 0,3 µm bis 200 µm ausgewählt sind.

4. Thermo-elektrischer Energiewandler nach einem der Ansprüche 1 bis 3, wobei die Mikro-Säulen übereinander zu einer Gesamt-Mikro-Säule (13) mit einer Gesamt-Längsausdehnung (131) aneinander angeordnet sind.

5. Thermo-elektrischer Energiewandler nach einem der Ansprüche 1 bis 4, wobei die Mikro-Säulen-Längsausdehnung zumindest einer der Mikro-Säulen oder die Gesamt-Mikro-Säulen-Längsausdehnung der Gesamt-Mikro-Säule oder aus dem Bereich von 50 µm bis 10 mm und insbesondere aus dem Bereich von 100 µm bis 1 mm ausgewählt ist.

6. Thermo-elektrischer Energiewandler nach einem der Ansprüche 1 bis 5, wobei die Mikro-Säulen derart nebeneinander angeordnet sind, dass zwischen den Mikro-Säulen ein Mikro-Säulen-Zwischenraum (14) mit einem zwischen den Mikro-Säulen aus dem Bereich von 0,3 µm bis 100 µm ausgewählten Mikro-Säulen-Abständ (141) resultiert.

7. Thermo-elektrischer Energiewandler nach einem der Ansprüche 1 bis 6, wobei im Mikro-Säulen-Zwischenraum zwischen den benachbarten Mikro-Säulen mindestens ein Mittel (142) zur thermischen Entkopplung der Mikro-Säulen voneinander angeordnet ist.

8. Thermo-elektrische Energiewandler nach Anspruch 7, wobei das Mittel zum thermischen Entkoppeln Vakuum mit einem Gasdruck von weniger als 10⁻² mbar ist.

9. Thermo-elektrischer Energiewandler nach einem der Ansprüche 1 bis 8, wobei die Mikro-Struktur mindestens eine Wärme-Kopplungs-Einrichtung (17) zum Einkoppeln von thermischer Energie in das Thermo-Paar und/oder zum Auskoppeln von thermischer Energie aus dem Thermo-Paar aufweist.

10. Thermo-elektrischer Energiewandler nach Anspruch 9, wobei die Wärme-Kopplungs-Einrichtung eine thermische Funktions-Schicht (171) zum Absorbieren von thermischer Energie in Form von thermischer Absorptions-Strahlung (18) und/oder zum Emittieren von thermischer Energie in Form von thermischer Emissions-Strahlung aufweist.

11. Thermo-elektrischer Energiewandler nach einem der vorhergehenden Ansprüche, wobei der Mikro-Struktur-Träger und der Schaltungs-Träger über Flip-Chip-Technologie miteinander verbunden sind.

12. Thermo-elektrischer Energiewandler nach einem der Ansprüche 1 bis 11, wobei die Mikro-Struktur eine Vielzahl der Thermo-Paare aufweist und die Vielzahl der Thermo-Paare seriell miteinander gekoppelt ist, so dass eine Summe der Thermo-Spannungen der Thermo-Paare im Wesentlichen eine Gesamt-Thermo-Spannung der Vielzahl der Thermo-Paare ergibt.

13. Verfahren zum Herstellen eines Thermo-elektrischen Energiewandlers nach einem Ansprüche 1 bis 12 mit folgenden Verfahrensschritten:
a) Bereitstellen einer Schablone (20) mit Schablonen-Material (201), wobei die Schablone eine im Wesentlichen zur Mikro-Struktur des thermo-elektrischen Energiewandlers inverse, drei dimensionale Schablonen-Struktur (202) mit säulenartigen Schablonen-Hohlräumen (203) aufweist,
b) Anordnen der Mikro-Säulen-Materialien in den säulenartigen Hohlräumen, so dass die Mikro-Säulen entstehen, und
c) zumindest teilweises Entfernen des Schablonen-Materials.

14. Verfahren nach Anspruch 13, wobei zum Anordnen der Mikro-Säulen-Materialien folgende weiteren Verfahrensschritte durchgeführt werden:
d) Einbringen von Ausgangs-Material zumindest einer der Mikro-Struktur-Materialien in die Hohlräume und e) Umwandeln des Ausgangs-Materials des Mikro-Struktur-Materials in das Mikro-Struktur-Material.

15. Verfahren nach Anspruch 13 oder 14, wobei eine Schablone mit Silizium als Schablonen-Material verwendet wird.

16. Verfahren nach einem der Ansprüche 13 bis 15, wobei eine Schablone mit einem Mikro-Struktur-Träger mit Träger-Material für die Mikro-Struktur verwendet wird.

17. Verwendung des thermo-elektrischen Energiewandlers nach einem der Ansprüche 1 bis 12 zum ineinander Umwandeln von thermischer Energie und elektrischer Energie, wobei durch die thermische Energie im Thermo-Paar die Thermo-Spannung erzeugt und so in elektrische Energie umgewandelt wird oder durch elektrische Ansteuerung des Thermo-Paares elektrische Energie in thermische Energie umgewandelt wird.

18. Verwendung nach Anspruch 17, wobei die elektrische Energie, die aus der thermischen Energie gewonnen wird, zum Nachweis der thermischen Energie verwendet wird.

19. Verwendung nach Anspruch 18, wobei thermische Energie in Form von thermischer Absorptions-Strahlung (18) verwendet wird.

## Claims

1. Thermoelectric energy converter (1) for converting thermal energy and electrical energy from one form to the other using at least one thermocouple, comprising at least one self-supporting, three-dimensional microstructure (10) having
- at least one first microcolumn (11), which has a first microcolumn longitudinal extent (111), a first microcolumn diameter (112) and at least one first microcolumn material (110) having a first thermopower, and
- at least one second microcolumn (12), which has a second microcolumn longitudinal extent (121), a second microcolumn diameter (122) and at least one second microcolumn material (120) having a second thermopower that is different compared with the first microcolumn material,
wherein
- the longitudinal extents (111, 121) of the microcolumns are arranged substantially parallel to one another,
- the microcolumn diameters (112, 122) are selected from the range 0.1 µm to 200 µm,
- the microcolumns (11, 12) each have an aspect ratio in the range 20 to 1000, and
- the microcolumns are coupled together as a thermocouple (15) to build up a thermoelectric voltage
- wherein a readout device (191) for reading out the thermoelectric voltage of the thermocouple and/or a drive device for driving the thermocouple by means of an electrical drive voltage are present,
**characterised in that**
the readout device and/or the drive device or parts thereof are integrated into a microstructure substrate, on which the microstructure is arranged and/or the readout device and/or the drive device or parts thereof are integrated into a circuit substrate (19) that is different from the microstructure substrate.

2. Thermoelectric energy converter according to claim 1, wherein the first microcolumn material and/or the second microcolumn material are selected from the group bismuth, antimony, tellurium and lead and compounds thereof.

3. Thermoelectric energy converter according to claim 1 or 2, wherein the microcolumn diameters are selected from the range 0.3 µm to 200 µm.

4. Thermoelectric energy converter according to any one of claims 1 to 3, wherein the microcolumns are arranged together one above the other into a total microcolumn (13) having a total longitudinal extent (131).

5. Thermoelectric energy converter according to any one of claims 1 to 4, wherein the microcolumn longitudinal extent of at least one of the microcolumns, or the total microcolumn longitudinal extent of the total microcolumn is selected from the range 50 µm to 10 mm, and in particular from the range of 100 µm to 1 mm.

6. Thermoelectric energy converter according to any one of claims 1 to 5, wherein the microcolumns are arranged side by side such that a microcolumn interstitial space (14) results between the microcolumns that has a microcolumn spacing (141) between the microcolumns selected from the range 0.3 µm to 100 µm.

7. Thermoelectric energy converter according to any one of claims 1 to 6, wherein a means (142) for thermally isolating the microcolumns from one another is arranged in the microcolumn interstitial space between the adjacent microcolumns.

8. Thermoelectric energy converter according to claim 7, wherein the thermal isolation means is a vacuum having a gas pressure of less than 10⁻² mbar.

9. Thermoelectric energy converter according to any one of claims 1 to 8, wherein the microstructure comprises at least one thermal coupling mechanism (17) for coupling thermal energy into the thermocouple and/or for coupling thermal energy out of the thermocouple.

10. Thermoelectric energy converter according to claim 9, wherein the thermal coupling mechanism comprises a thermal functional layer (171) for absorbing thermal energy in the form of absorbed thermal radiation (18) and/or for emitting thermal energy in the form of emitted thermal radiation.

11. Thermoelectric energy converter according to any one of the preceding claims, wherein the microstructure is arranged on a microstructure substrate (16).

12. Thermoelectric energy converter according to any one of claims 1 to 11, wherein the microstructure comprises a multiplicity of thermocouples, and the multiplicity of thermocouples are connected together in series so that a sum of the thermoelectric voltages of the thermocouples produces substantially a total thermoelectric voltage of the multiplicity of thermocouples.

13. Method for producing a thermoelectric energy converter according to any one of claims 1 to 12, comprising the following method steps of:
a) providing a template (20) comprising template material (201), the template having a three-dimensional template structure (202) that is substantially the inverse of the microstructure of the thermoelectric energy converter and comprises columnar template cavities (203),
b) arranging the microcolumn materials in the columnar cavities so as to produce the microcolumns, and
c) removing the template material at least partially.

14. Method according to claim 13, wherein the following additional method steps are carried out in order to arrange the microcolumn materials:
d) introducing starting material for at least one of the microcolumn materials into the cavities, and
e) converting the starting material for the microstructure material into the microstructure material.

15. Method according to claim 13 or 14, wherein a template containing silicon as the template material is used.

16. Method according to any one of claims 13 to 15, wherein a template having a microstructure substrate comprising substrate material is used for the microstructure.

17. Use of the thermoelectric energy converter according to any one of claims 1 to 12 for converting thermal energy and electrical energy from one form to the other, wherein the thermal energy in the thermocouple produces the thermoelectric voltage and thus is converted into electrical energy, or electrical energy is converted into thermal energy by driving the thermocouple electrically.

18. Use according to claim 17, wherein the electrical energy obtained from the thermal energy is used to detect the thermal energy.

19. Use according to claim 18, wherein thermal energy is used in the form of absorbed thermal radiation (18).

## Revendications

1. Convertisseur d'énergie thermoélectrique (1) pour une conversion réciproque d'énergie thermique et d'énergie électrique avec au moins un élément thermoélectrique, présentant au moins une micro-structure (10) tridimensionnelle autoportante avec
- au moins une première micro-colonne (11), qui présente une première étendue longitudinale (111) de micro-colonne, un premier diamètre (112) de micro-colonne et au moins un premier matériau (110) de micro-colonne avec une première force thermoélectrique, et
- au moins une seconde micro-colonne (12), qui présente une seconde étendue longitudinale (121) de micro-colonne, un second diamètre (122) de micro-colonne et au moins un second matériau (120) de micro-colonne avec une seconde force thermoélectrique différente de celle du premier matériau de micro-colonne,
dans lequel
- les micros-colonnes, en ce qui concerne les étendues longitudinales (111, 121), sont agencées de manière essentiellement parallèle les unes aux autres,
- les diamètres (112, 122) de micro-colonne sont sélectionnés dans la plage de 0,1 µm à 200 µm,
- les micro-colonnes (11, 12) présentent respectivement un rapport d'aspect dans la plage de 20 à 1000 et
- les micro-colonnes sont couplées les unes aux autres en tant que thermocouples (15) pour accumuler une tension thermoélectrique,
- dans lequel sont présents un appareil de sélection (191) pour une sélection de la tension thermoélectrique du thermocouple et/ou un appareil d'activation pour une activation du thermocouple avec une tension électrique d'activation,
**caractérisé en ce que**
l'appareil de sélection et/ou l'appareil d'activation ou des parties de ceux-ci sont intégrés dans un support de micro-structure, sur lequel est agencée la micro-structure, et/ou l'appareil de sélection et/ou l'appareil d'activation ou des parties de ceux-ci sont intégrés dans un support de circuit (19) différent du support de micro-structure.

2. Convertisseur d'énergie thermoélectrique selon la revendication 1, dans lequel le premier matériau de micro-colonne et/ou le second matériau de micro-colonne est ou sont sélectionné(s) parmi le groupe constitué de bismuth, antimoine, tellure et plomb ainsi que des composés de ceux-ci.

3. Convertisseur d'énergie thermoélectrique selon la revendication 1 ou 2, dans lequel les diamètres de micro-colonne sont sélectionnés dans la plage de 0,3 µm à 200 µm.

4. Convertisseur d'énergie thermoélectrique selon l'une quelconque des revendications 1 à 3, dans lequel les micro-colonnes sont agencées de manière superposée les unes au niveau des autres pour donner une micro-colonne totale (13) présentant une étendue longitudinale totale (131).

5. Convertisseur d'énergie thermoélectrique selon l'une quelconque des revendications 1 à 4, dans lequel l'étendue longitudinale de micro-colonne d'au moins une des micro-colonnes ou l'étendue longitudinale totale de micro-colonne de la micro-colonne totale est sélectionnée dans la plage de 50 µm à 10 mm et en particulier dans la plage de 100 µm à 1 mm.

6. Convertisseur d'énergie thermoélectrique selon l'une quelconque des revendications 1 à 5, dans lequel les micro-colonnes sont agencées les unes à côté des autres de telle manière qu'il en résulte entre les micro-colonnes un espacement (14) de micro-colonnes avec un écartement (141) de micro-colonnes sélectionné dans la plage de 0,3 µm à 100 µm entre les micro-colonnes.

7. Convertisseur d'énergie thermoélectrique selon l'une quelconque des revendications 1 à 6, dans lequel au moins un moyen (142) pour un découplage thermique des micro-colonnes les unes par rapport aux autres est agencé dans l'espacement de micro-colonnes entre les micro-colonnes adjacentes.

8. Convertisseur d'énergie thermoélectrique selon la revendication 7, dans lequel le moyen pour un découplage thermique est un vide présentant une pression de gaz inférieure à 10⁻² mbar.

9. Convertisseur d'énergie thermoélectrique selon l'une quelconque des revendications 1 à 8, dans lequel la micro-structure présente au moins un appareil de couplage de chaleur (17) pour un couplage d'énergie thermique dans le thermocouple et/ou pour un découplage d'énergie thermique à partir du thermocouple.

10. Convertisseur d'énergie thermoélectrique selon la revendication 9, dans lequel l'appareil de couplage de chaleur présente une couche fonctionnelle thermique (171) pour une absorption d'énergie thermique sous la forme d'un rayonnement thermique d'absorption (18) et/ou pour une émission d'énergie thermique sous la forme d'un rayonnement thermique d'émission.

11. Convertisseur d'énergie thermoélectrique selon l'une quelconque des revendications précédentes, dans lequel le support de micro-structure et le support de circuit sont reliés l'un avec l'autre par l'intermédiaire d'une technologie de puce retournée.

12. Convertisseur d'énergie thermoélectrique selon l'une quelconque des revendications 1 à 11, dans lequel la micro-structure présente une pluralité de thermocouples et la pluralité de thermocouples sont couplés les uns avec les autres de manière sérielle, de sorte qu'une somme des tensions thermoélectriques des thermocouples donne essentiellement une tension thermoélectrique totale de la pluralité de thermocouples.

13. Procédé pour une production d'un convertisseur d'énergie thermoélectrique selon l'une quelconque des revendications 1 à 12, comprenant les étapes de procédé suivantes consistant à :
a) préparer un gabarit (20) avec un matériau de gabarit (201), le gabarit présentant une structure de gabarit (202) tridimensionnelle, essentiellement inverse par rapport à la micro-structure du convertisseur d'énergie thermoélectrique, avec des cavités (203) de gabarit de type colonne,
b) agencer les matériaux de micro-colonne dans les cavités de type colonne de manière à former les micro-colonnes, et
c) éliminer au moins partiellement le matériau de gabarit.

14. Procédé selon la revendication 13, dans lequel sont mises en oeuvre, pour un agencement des matériaux de micro-colonne, les autres étapes de procédé suivantes consistant à :
d) introduire dans les cavités une matière première d'au moins un des matériaux de microstructure et
e) transformer la matière première du matériau de microstructure en matériau de micro-structure.

15. Procédé selon la revendication 13 au 14, dans lequel un gabarit présentant du silicium est utilisé en tant que matériau de gabarit.

16. Procédé selon l'une quelconque des revendications 13 à 15, dans lequel un gabarit présentant un support de microstructure est utilisé avec un matériau de support pour la micro-structure.

17. Utilisation du convertisseur d'énergie thermoélectrique selon l'une quelconque des revendications 1 à 12 pour une conversion réciproque d'énergie thermique et d'énergie électrique, dans lequel la tension thermoélectrique est produite grâce à l'énergie thermique dans le thermocouple et est ainsi convertie en énergie électrique ou de l'énergie électrique est convertie en énergie thermique grâce à une activation électrique du thermocouple.

18. Utilisation selon la revendication 17, dans laquelle l'énergie électrique qui est obtenue à partir de l'énergie thermique est utilisée pour une mise en évidence de l'énergie thermique.

19. Utilisation selon la revendication 18, dans laquelle l'énergie thermique est utilisée sous la forme d'un rayonnement thermique d'absorption (18).
